# FASCICULE DE BREVET EUROPEEN

(11) **EP 1 998 183 B1**
(45) Date de publication et mention de la délivrance du brevet: **16.03.2011**
(21) Numéro de dépôt: 08157348.7
(22) Date de dépôt: 30.05.2008
(51) Int. Cl.: G01R 31/00, G01R 31/317, G01R 31/319, G05B 23/02, G06F 11/07, G07C 5/08, B60W 40/00

(54) **Système d`aide au diagnostic pour véhicule automobile**
Diagnosehilfssystem für Kraftfahrzeug
Diagnosis assistance system for an automobile vehicle

(30) Priorité: 01.06.2007 FR 0755415
(43) Date de publication de la demande: 03.12.2008
(73) Titulaire: PEUGEOT CITROËN AUTOMOBILES SA, 78140 Vélizy Villacoublay (FR)
(72) Inventeur: Lopez, Thierry, 78700, CONFLANS-STE-HONORINE (FR)
(74) Mandataire: Ménès, Catherine

(56) Documents cités:
- WO-A-00/60548
- WO-A-02/103316

## Description

La présente invention concerne un système d'aide au diagnostic pour véhicule automobile.

Pour le réseau après-vente d'un constructeur automobile, en charge de la maintenance des véhicules, la croissance de l'électronique embarquée a engendré une complexité de type exponentiel. Cette complexité est encore accrue par l'obligation faite en vertu de l'application du NRE (Nouveau Règlement Européen : Directive 2002/CE/1400) de permettre aux réparateurs indépendants d'accéder librement et sans restriction aux opérations de réparation lors de la commercialisation de ces véhicules.

Sous ce terme d'opérations de réparation est regroupé un ensemble de fonctionnalités de natures diverses. Le réparateur disposera aussi bien de la possibilité de lire des informations depuis le véhicule que de piloter un ou plusieurs actionneurs dans un cadre défini afin d'en contrôler le bon fonctionnement ou de réaliser par exemple une opération de remplissage du bloc ABS. D'autres fonctionnalités regroupées sous ce terme permettront même de procéder à une mise à niveau du logiciel contenu dans un calculateur dans le but de corriger une prestation ou de remettre le véhicule en état.

Cependant, bien qu'il soit intégré dans chacun des calculateurs du véhicule de plus en plus d'autodiagnostic (capacité du système à surveiller et détecter ses propres défaillances) et développé continuellement de nouveaux modèles dans les outils associés, il reste toujours difficile de retrouver le contexte exact d'apparition d'une défaillance. Or, ce contexte est souvent d'une aide précieuse pour le réparateur.

Pour cela, chaque calculateur enregistre au moment de la détection d'une anomalie, un code de défaut ainsi que des paramètres fonctionnels tels le régime moteur, la tension de la batterie, la vitesse du véhicule ou la température d'eau moteur, etc., apportant ainsi une aide au réparateur notamment lorsque la défaillance indiquée concerne un ensemble de pièces potentiellement incriminées (il est par exemple possible de dire que le défaut n'apparaît qu'au-delà de 110 km/h et qu'il n'est pas opportun d'essayer de le mettre en évidence au ralenti).

Aujourd'hui, l'ensemble des paramètres d'environnement enregistrés associés à une défaillance sont en fait des paramètres fonctionnels du véhicule. Il apparaît néanmoins intéressant d'y associer des paramètres liés au dysfonctionnel du véhicule. Ce terme regroupe un ensemble de situations de vie véhicule qui ne sont pas celles de l'utilisation du client final.

On y trouve notamment les situations de mise en service du produit, de maintenance ou de contrôle technique tel que réalisé aujourd'hui dans certains pays. Les phases plus particulièrement intéressantes sont déterminées par la présence d'un outil connecté sur le véhicule. Bien que "réduites", leur nombre ainsi que la combinatoire des situations imaginables font qu'il reste impossible pour l'embarqué de réaliser un traitement exhaustif des anomalies associées. Or, il existe de nombreux cas où c'est justement le déclenchement d'une opération sur un organe ou calculateur dans une de ces phases qui va induire la détection de défaillances au sein d'autres calculateurs du véhicule.

Il est important de noter que l'utilisation d'un outil de diagnostic connecté sur un véhicule roulant est une situation courante. En effet, après une opération de maintenance, il est tout à fait envisageable que le réparateur effectue un circuit de roulage tout en contrôlant depuis l'outil, les paramètres usuels de bon fonctionnement du véhicule.

Les outils des constructeurs prennent en compte de par leur conception ces aspects, mais le fait que tout un chacun puisse fabriquer son propre outil de diagnostic qui vienne perturber le fonctionnel du véhicule lors de la connexion sur la prise centralisée de diagnostic du véhicule, peut conduire à l'enregistrement de codes défauts dans les calculateurs sans que l'opérateur en question ne puisse faire la liaison avec l'opération de maintenance elle-même. De ce fait, il existe un risque non négligeable que le client se tourne alors vers le réseau constructeur de la marque et présente un véhicule contenant ces nouveaux défauts en mémoire.

On connait de WO 01/60548 un moyen d'aide à l'entretien d'un véhicule équipé de différents éléments tels que des capteurs qui peuvent se connecter à un bus de données CAN. Ces éléments sont munis de moyens d'autodiagnostic. Un outil de diagnostic est de plus capable de se connecter au bus de données et générer des codes d'erreurs lorsqu'un capteur est auto-diagnostiqué défaillant. Par ailleurs, selon D1, on prévoit une carte mémoire de données ayant une très large capacité, capable notamment de stocker tout l'historique les codes erreurs ainsi que des paramètres de fonctionnement du véhicule. Lors d'une maintenance du véhicule, cette carte mémoire peut être lue par un lecteur adapté, l'historique complet aidant à diagnostiquer une panne.

WO 02/103316 décrit par ailleurs le principe du système de diagnostic embarqué dit OBD (On Board Diagnostic), la récupération des codes erreurs générés et le traitement des ces erreurs, en soulignant la difficulté liée au volume de données.

Dans un tel cas, une aide précieuse pour le réparateur serait de disposer d'un moyen de discriminer de la mémoire ce type de défauts de ceux issus d'une défaillance d'un organe du véhicule.

Le but de l'invention est donc de résoudre ces problèmes.

A cet effet, l'invention a pour objet un système d'aide au diagnostic de calculateurs embarqués dans un véhicule, chaque calculateur comportant des moyens d'autodiagnostic et des moyens d'enregistrement d'un disfonctionnement auto-détecté par un calculateur, et l'ensemble des calculateurs étant reliés à un réseau, ledit réseau étant adapté à une connexion à un outil, notamment pour une opération de maintenance ou de diagnostic, caractérisé en ce qu'il comporte
- des moyens de détection de la connexion d'un outil (6) au réseau et de la liste des calculateurs avec lesquels l'outil (6) est en phase de communication ;
- des moyens d'émission à l'ensemble des calculateurs d'une information d'environnement correspondant à ladite liste ;
- des moyens d'enregistrement de ladite information d'environnement lorsqu'un défaut est auto-détecté par un calculateur.

L'enregistrement de l'environnement du capteur au moment du constat d'un disfonctionnement repéré par les moyens d'autodiagnostic permet de simplifier l'analyse ultérieure du disfonctionnement, et en particulier de ne pas tenir compte de disfonctionnement lié simplement à la connexion avec un outil, comme par exemple un outil destiné à contrôler les émissions d'un véhicule lors d'un contrôle anti-pollution.

L'invention a également pour objet un outil de diagnostic adapté à la lecture de l'ensemble des enregistrements de dysfonctionnement auto-détectés par des calculateurs embarqués dans un véhicule, reliés à un réseau adapté à la connexion de l'outil et comportant un système d'aide au diagnostic conforme à l'une quelconque des revendications 1 à 6, caractérisé en ce que l'outil de diagnostic comporte un modèle, apte à effacer de la mémoire des calculateurs les disfonctionnements enregistrés dans certaines situation d'environnement. Autrement dit, on associe à un outil de diagnostic un modèle qui va permettre d'indiquer au réparateur de ne pas tenir compte de disfonctionnement qui auront été générer dans des situations de communication avec un autre outil, et qui pourront être simplement considérer comme la trace d'une intervention, non d'un disfonctionnement effectif.

Suivant des modes particuliers de réalisation, le système comporte l'une ou plusieurs des caractéristiques suivantes :
- les moyens de détection et les moyens d'émission sont intégrés dans un calculateur unique du réseau,
- ce calculateur est associé à des moyens de stockage d'une table d'identification de l'exhaustivité des identifiants de trames utilisées pour les sessions de communication des calculateurs du réseau avec l'outil de diagnostic,
- des moyens de détection et des moyens d'émission sont intégrés dans chaque calculateur du réseau,
- le réseau de calculateur comporte un réseau de transmission d'informations raccordant les différents calculateurs entre eux et à une prise de diagnostic à laquelle peut être connecté l'outil de diagnostic,
le réseau de transmission d'informations est un réseau CAN.

L'invention sera mieux comprise à l'aide de la description qui va suivre donnée uniquement à titre d'exemple, et faite en se référant aux dessins annexés sur lesquels :
- la figure1 représente un schéma synoptique illustrant un premier mode de réalisation d'une portion du système selon l'invention,
- la figure 2 représente un schéma synoptique illustrant un second mode de réalisation de cette portion du système selon l'invention, et
- la figure 3 représente un schéma synoptique illustrant un mode de réalisation d'une autre portion du système selon l'invention.

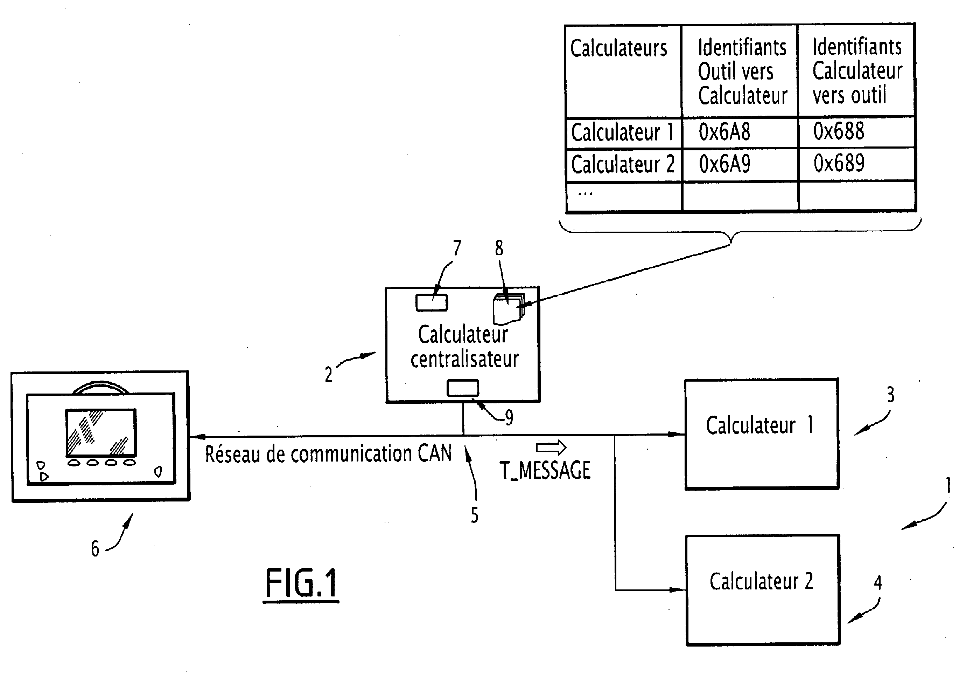

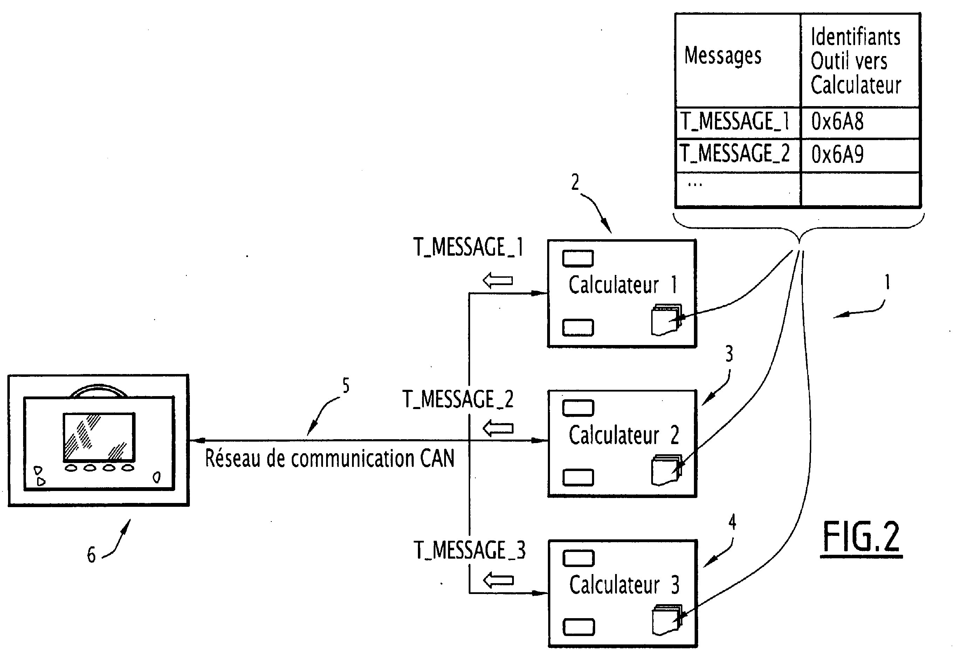

On reconnaît en effet sur ces figures, et en particulier sur les figures 1 et 2, un réseau de calculateurs embarqués à bord d'un véhicule, ce réseau de calculateurs étant désigné par la référence générale 1 sur cette figure.

Ce réseau de calculateurs comporte par exemple plusieurs calculateurs dont trois désignés par les références générales 2, 3 et 4, sont illustrés sur cette figure, ces calculateurs étant raccordés par un réseau de transmission d'informations désigné par la référence générale 5, constitué par exemple par un réseau de transmission de type CAN ou autres.

Ce réseau peut par exemple être raccordé à une prise de diagnostic permettant de raccorder celui-ci à un outil extérieur de diagnostic désigné par la référence générale 6, de façon classique.

De façon classique également, chaque calculateur comporte des moyens d'autodiagnostic qui ne seront pas décrits plus en détails par la suite.

Pour résoudre les différents problèmes mentionnés précédemment, le mécanisme mis en oeuvre par l'invention peut être décomposé en deux sous-mécanismes distincts, à savoir un premier sous mécanisme qui consiste en la détection du fait qu'un outil de diagnostic soit connecté au véhicule et en phase de communication avec un ou plusieurs calculateurs de celui-ci et un second sous-mécanisme qui consiste ensuite pour chaque calculateur lors de la détection d'une défaillance depuis son module de surveillance et d'autodiagnostic embarqué, à enregistrer en tant que paramètres associés de l'environnement au code de défaut de la défaillance, l'identité du ou des calculateurs qui étaient en phase de communication avec l'outil.

Enfin, un modèle débarqué dans l'outil de diagnostic permet d'indiquer au réparateur qu'en présence de tel défaut et de telles ou telles identités de calculateurs en situation de communication avec l'outil, le défaut peut être effacé de la mémoire du véhicule sans autre forme de traitement c'est-à-dire de faciliter l'analyse ultérieure du dysfonctionnement détecté.

A cet effet et pour le premier sous mécanisme, deux modes de réalisation possibles peuvent être envisagés en fonction de l'architecture retenue du véhicule c'est-à-dire de l'architecture du réseau de communication.

Ceux-ci sont illustrés sur les figures 1 et 2.

Selon le premier mode de réalisation illustré sur la figure 1, un calculateur joue le rôle de centralisateur des détections d'entrée en session de communication des autres calculateurs. Pour cela, il dispose de moyens de stockage en interne d'une table d'identification de l'exhaustivité des identifiants de trames utilisées pour les sessions de communication des calculateurs du véhicule avec l'outil et transmet dans une unique trame fonctionnelle en diffusion (à destination de l'ensemble des calculateurs à l'écoute) un message T_MESSAGE contenant soit la valeur INIT positionnée par défaut lors de la mise sous tension, soit la valeur de l'identifiant de la trame d'ouverture de session de communication reconnu par comparaison avec la table inscrite dans sa mémoire.

Ce message est ensuite repositionné à la valeur INIT lors de la fermeture d'une session de communication de telle sorte que tous les autres calculateurs du véhicule sont en mesure par la surveillance de la seule trame émise par le calculateur centralisateur qui contient le message T_MESSAGE, d'en mémoriser la valeur comme l'un des paramètres de contexte associé lors de la détection d'un défaut depuis leurs propres stratégies.

On a en effet illustré sur cette figure 1, un calculateur centralisateur formé par le calculateur 2 qui comporte alors des moyens 7 de détection de trames d'identifiants de communication avec un outil, circulant sur le réseau CAN, c'est-à-dire des moyens de détection du lancement d'une opération de diagnostic par celui-ci, des moyens de stockage de la table d'identification des identifiants de trames utilisées, désignés par la référence générale 8 et enfin des moyens 9 d'émission sur le réseau CAN à destination des autres calculateurs de l'information de détection correspondante sous la forme d'une trame par exemple de la valeur T_MESSAGE.

L'avantage principal de ce mode de réalisation résulte du fait que les calculateurs du véhicule autres que le calculateur centralisateur n'ont qu'une seule trame à surveiller en provenance de ce dernier. Par contre, le calculateur centralisateur devra disposer d'une version de la table d'identifiants par variante de véhicule à produire.

Au niveau du calculateur centralisateur, un autre désavantage est lié à la difficulté de borner précisément la fin de communication entre l'outil et un autre calculateur du véhicule. Pour réaliser cela, il lui sera nécessaire de disposer dans la table en mémoire, de l'exhaustivité des identifiants de trames de réponse des calculateurs à l'outil, mais surtout d'analyser le contenu de ces trames afin d'y reconnaître le message de fermeture de session de communication.

De plus, dans le cadre d'un adressage de type fonctionnel où chaque calculateur répond à une seule et même demande de l'outil en diffusion et ce, en vertu du mécanisme d'arbitrage des priorités disponible sur le réseau CAN, la calculateur centralisateur doit également disposer dans son mécanisme de détection de fin de communication, d'une fonction lui permettant de s'assurer que tous les calculateurs susceptibles de répondre à une demande l'ont bien fait.

Le second mode de réalisation illustré sur la figure 2 repose sur le principe suivant : il est possible pour chaque calculateur sollicité par un outil de transmettre sur une trame de la messagerie fonctionnelle au moyen d'un signal T_MESSAGE_X le fait qu'il est engagé ou non dans une session de communication. Pour cela, chaque calculateur peut positionner ce signal à l'état COM_NON_ENGAGEE par défaut lors de la mise sous tension et le placer à l'état COM_ENGAGEE lors de la réception d'une demande de session de communication.

Les avantages de ce second mode de réalisation sont d'une part qu'il reste simple pour chaque calculateur de détecter et donc de synchroniser précisément le signal T_MESSAGE_X transmis par ses soins sur le début et la fin d'une demande de session de communication avec l'outil et d'autre part, tant les identifiants de trames de communication des calculateurs vers l'outil que le contenu de ce type de trames ne sont à surveiller par aucun calculateur car non nécessaires dans ce cadre.

L'inconvénient principal de ce mode de réalisation est de surveiller depuis chaque calculateur les trames contenant les messages T_MESSAGE_X émises par chacun des autres calculateurs connectés sur le réseau. La table de transcodage entre les messages T_MESSAGE_X reçus et les identifiants associés peut être soit embarquée dans chaque calculateur, soit débarquée dans l'outil.

On conçoit alors que dans ce mode de réalisation, des moyens de détection et des moyens d'émission sont intégrés dans chaque calculateur du réseau.

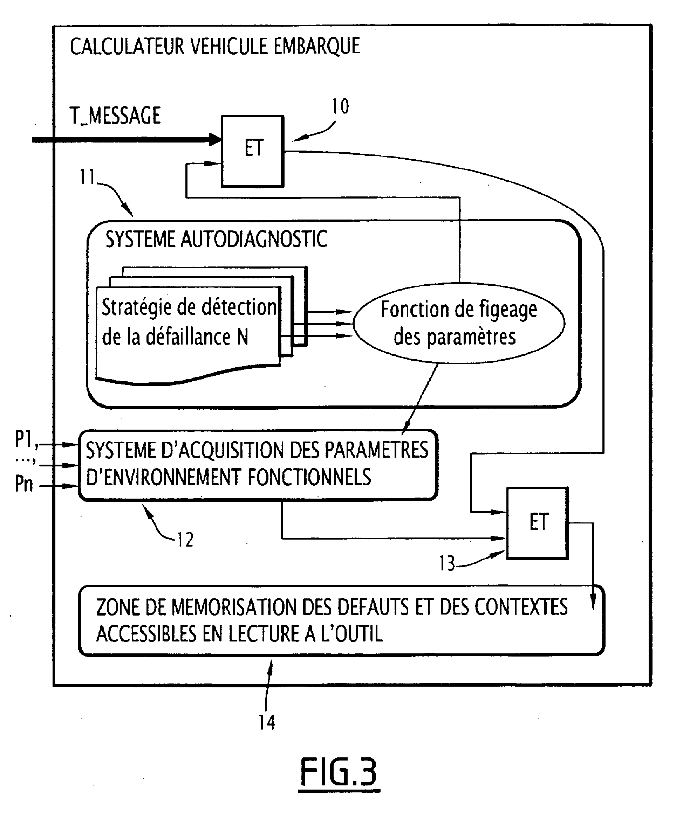

La figure 3 illustre quant à elle la décomposition fonctionnelle en mémoire des calculateurs, permettant pour chaque calculateur lors de la détection d'une défaillance depuis son module de surveillance ou d'autodiagnostic embarqué, à enregistrer en tant que paramètre associé d'environnement au code de défaut de la défaillance, l'identité du ou des calculateurs qui étaient dans une phase de communication avec un outil.

Ceci est illustré par exemple par une porte ET 10 combinant la sortie du système d'autodiagnostic 11 embarqué à l'information de détection du lancement d'une opération de diagnostic correspondante et aux différents paramètres d'environnement fonctionnels tels que détectés par des moyens correspondants 12 pour, après passage dans une nouvelle fonction ET 13, accéder à une zone de mémorisation 14 des défauts et des contextes, accessible en lecture à l'outil de diagnostic connecté au véhicule.

En fonction du sous mécanisme utilisé, que ce soit celui décrit en regard de la figure 1 ou celui de la figure 2, T_MESSAGE soit contient la valeur de l'identité du calculateur en communication avec l'outil pour le premier mode de réalisation soit est un multiple (T_MESSAGE par calculateur dans le second mode de réalisation illustré sur la figure 2) et contient simplement un signal indiquant que le calculateur émetteur du signal est en cours de communication avec l'outil. Dans ce cas, le calculateur stocke dans la zone de mémorisation 14 des défauts et des contextes associés accessible en lecture, la valeur correspondant à l'identité du calculateur émetteur de T_MESSAGE. Une telle structure permet de faire baisser significativement le temps d'intervention et d'analyse ultérieure du dysfonctionnement détecté.

Le système selon l'invention apporte également un critère de filtrage supplémentaire dans le cadre du contrôle en usine de fabrication du constructeur où sont rencontrées une multitude de situations (mise sous tension de calculateurs alors que d'autres ne sont pas connectés, etc). Enfin lors de la mise au point du véhicule, phase toujours délicate où de nombreux compromis sont nécessaires pour l'obtention de stratégies de détection de défaillances entre la robustesse vis-à-vis d'alertes intempestives et d'efficacité vis-à-vis de la protection du client et du matériel, le système selon l'invention permet de réduire un certain nombre de facteurs de dispersion.

Bien entendu, d'autres modes de réalisation encore peuvent être envisagés.

## Revendications

1. Système d'aide au diagnostic de calculateurs (3, 4) embarqués dans un véhicule, chaque calculateur (2, 3, 4) comportant des moyens d'autodiagnostic et des moyens d'enregistrement d'un disfonctionnement auto-détecté par un calculateur, et l'ensemble des calculateurs étant reliés à un réseau (1), ledit réseau étant adapté à une connexion à un outil (6), notamment pour une opération de maintenance ou de diagnostic, **caractérisé en ce qu'**il comporte
• des moyens de détection de la connexion d'un outil (6) au réseau et de la liste des calculateurs avec lesquels l'outil (6) est en phase de communication ;
• des moyens d'émission à l'ensemble des calculateurs d'une information d'environnement correspondant à ladite liste ;
• des moyens d'enregistrement de ladite information d'environnement lorsqu'un défaut est auto-détecté par un calculateur.

2. Système selon la revendication 1, **caractérisé en ce que** les moyens de détection et les moyens d'émission sont intégrés dans un calculateur unique (2) du réseau.

3. Système selon la revendication 2, **caractérisé en ce que** ce calculateur (2) est associé à des moyens (8) de stockage d'une table d'identification de l'exhaustivité des identifiants de trames utilisées pour les sessions de communication des calculateurs du réseau avec l'outil (6).

4. Système selon la revendication 1, **caractérisé en ce que** des moyens de détection et des moyens d'émission sont intégrés dans chaque calculateur du réseau.

5. Système selon l'une quelconque des revendications précédentes, **caractérisé en ce que** le réseau de calculateur comporte un réseau de transmission d'informations (5) raccordant les différents calculateurs (2, 3, 4) entre eux et à une prise de diagnostic à laquelle peut être connecté l'outil (6).

6. Système selon la revendication 5, **caractérisé en ce que** le réseau de transmission d'informations (5) est un réseau CAN.

7. Outil de diagnostic adapté à la lecture de l'ensemble des enregistrements de dysfonctionnement auto-détectés par des calculateurs embarqués dans un véhicule, reliés à un réseau adapté à la connexion de l'outil et comportant un système d'aide au diagnostic conforme à l'une quelconque des revendications 1 à 6, **caractérisé en ce que** l'outil de diagnostic comporte un modèle, apte à effacer de la mémoire des calculateurs les disfonctionnements enregistrés dans certaines situation d'environnement.

## Claims

1. Diagnosis assistance system of onboard computers (3, 4) in a vehicle, each computer (2, 3, 4) comprising autodiagnostic means and recording means of a malfunction auto-detected by a computer, and the set of computers being connected to a network (1), the said network being adapted to a connection to a tool (6), in particular for a maintenance or diagnosis operation, **characterized in that** it comprises
• detecting means of the connection of a tool (6) to the network and of the list of computers with which the tool (6) is in communication phase;
• emission means to the set of computers of environmental information corresponding to the said list;
• recording means of the said environmental information when a fault is auto-detected by a computer.

2. System according to Claim 1, **characterized in that** the detecting means and the emission means are integrated in a single computer (2) of the network.

3. System according to Claim 2, **characterized in that** this computer (2) is associated with storage means (8) of an identification table of the exhaustivity of the identifiers of frames used for the communication sessions of the computers of the network with the tool (6).

4. System according to Claim 1, **characterized in that** detecting means and emission means are integrated in each computer of the network.

5. System according to any one of the preceding claims, **characterized in that** the computer network comprises a data transmission network (5) connecting the different computers (2, 3, 4) between each other and to a diagnostic socket to which the tool (6) can be connected.

6. System according to Claim 5, **characterized in that** the data transmission network (5) is a CAN network.

7. Diagnosis tool adapted to the reading of all the auto-detected malfunction recordings by onboard computers in a vehicle, connected to a network adapted to the connection of the tool and comprising a diagnosis assistance system according to any one of Claims 1 to 6, **characterized in that** the diagnosis tool comprises a model, able to delete from the memory of the computers the recorded malfunctions under certain environmental situations.

## Patentansprüche

1. Diagnosehilfssystem für Rechner (3, 4), die in einem Fahrzeug mitgeführt werden, wobei jeder Rechner (2, 3, 4) Mittel zur Selbstdiagnose und Mittel zum Aufzeichnen einer von einem Rechner selbst erkannten Funktionsstörung aufweist, und wobei alle Rechner an ein Netz (1) angeschlossen sind, wobei das Netz an ein Werkzeug (6) angeschlossen werden kann, insbesondere für eine Wartungs- oder Diagnoseoperation, **dadurch gekennzeichnet, dass** es Folgendes aufweist:
• Mittel zum Erfassen des Anschließens eines Werkzeugs (6) an das Netz und der Liste der Rechner, mit welchen das Werkzeug (6) in Kommunikationsphase ist;
• Mittel zum Senden einer Umgebungsinformation, die der Liste entspricht, an alle Rechner;
• Mittel zum Aufzeichnen der Umgebungsinformation, wenn ein Rechner einen Fehler selbst erkennt.

2. System nach Anspruch 1, **dadurch gekennzeichnet, dass** die Erfassungs- und die Sendemittel in einen einzigen Rechner (2) des Netzes eingebaut sind.

3. System nach Anspruch 2, **dadurch gekennzeichnet, dass** dieser Rechner (2) mit Mitteln (8) zum Speichern einer Identifikationstabelle der Vollständigkeit der Identifikatoren von Rahmen, die für die Kommunikationssessions der Rechner des Netzes mit dem Werkzeug (6) verwendet werden, verbunden ist.

4. System nach Anspruch 1, **dadurch gekennzeichnet, dass** die Erfassungs- und Sendemittel in jeden Rechner des Netzes eingebaut sind.

5. System nach einem der vorhergehenden Ansprüche, **dadurch gekennzeichnet, dass** das Rechnernetz ein Datenübertragungsnetz (5) aufweist, das die verschiedenen Rechner (2, 3, 4) untereinander und mit einer Diagnoseabgriffstelle, an die das Werkzeug (6) angeschlossen werden kann, verbindet.

6. System nach Anspruch 5, **dadurch gekennzeichnet, dass** das Datenübertragungsnetz (5) ein CAN-Netz ist.

7. Diagnosewerkzeug, das alle Aufzeichnungen von Funktionsstörungen lesen kann, die von Rechnern, die in einem Fahrzeug mitgeführt werden, die an ein Netz angeschlossen sind, an das das Werkzeug angeschlossen werden kann, selbst erkannt wurden, und das ein Diagnoseunterstützungssystem nach einem der Ansprüche 1 bis 6 aufweist, **dadurch gekennzeichnet, dass** das Diagnosewerkzeug ein Modell enthält, das aus dem Speicher der Rechner die in bestimmten Umgebungssituationen aufgezeichneten Funktionsstörungen löschen kann.
